# EUROPÄISCHE PATENTSCHRIFT

(11) **EP 0 637 874 B1**
(45) Veröffentlichungstag und Bekanntmachung des Hinweises auf die Patenterteilung: **01.04.1998**
(21) Anmeldenummer: 94111496.9
(22) Anmeldetag: 22.07.1994
(51) Int. Cl.: H03K 17/687, G08B 29/02

(54) **MOS-Schaltstufe**
MOS switching stage
Etage de commutation MOS

(30) Priorität: 02.08.1993 DE 4325899
(43) Veröffentlichungstag der Anmeldung: 08.02.1995
(73) Patentinhaber: SIEMENS AKTIENGESELLSCHAFT, 80333 München (DE)
(72) Erfinder: Zitta, Heinz, Dipl.-Ing., A-9580 Drobollach (AT)

(56) Entgegenhaltungen:
- JP-A- 2 164 268
- JP-A- 4 167 814
- JP-A- 5 191 970
- JP-A-56 091 531
- ARCHIV FüR ELEKTROTECHNIK, Bd.72, 1989, SPRINGER-VERLAG Seiten 83 - 88 J. KRAUSE ET AL.: 'Smart SIPMOS: Der intelligente Leistungsschalter'
- PATENT ABSTRACTS OF JAPAN vol. 8, no. 213 (E-269) (1650) 28. September 1984 & JP-A-59 097 223 (NISSAN JIDOSHA K. K.) 5. Juni 1984

## Beschreibung

Die Erfindung betrifft eine Schaltungsanordnung mit einem MOS-Transistor, dessen Dran-Anschluß mit einer Ladungspumpe verbunden ist, die den Gate-Anschluß des Transistors steuert.

An Leistungsschalter werden bei bestimmten Anwendungen hohe Funktions- und Zuverlässigkeitsanforderungen gestellt. Dies trifft insbesondere für den Einbau von Leistungsschaltern in sicherheitsrelevanten Schaltungsanordnungen zu. Lediglich ein Beispiel für eine derartige Anwendung ist ein ABS-System in der Automobiltechnik, dessen Kontrollampe in jedem möglichen Fehlerfall leuchten soll. Üblicherweise liegt die Kontrollampe im Lastkreis eines Leistungstransistors, der in einem Fehlerfall von einer Ansteuereinrichtung durchgeschaltet wird. Wenn die Kontrollampe auch bei einem Ausfall der Ansteuereinrichtung, beispielsweise wenn diese auf Grund einer Leitungsunterbrechung nicht mit Spannung versorgt wird, ansprechen soll, muß die Transistorschaltstufe für die Kontroll-lampe selbstleitend sein.

Bei einer Ausbildung der Schaltstufe in bipolarer Technik ist ein Darlington-Transistor vorgesehen, der von einer Ansteuereinrichtung gesteuert wird. Der Kollektor der Darlington-Stufe ist über einen als Kontrollampe aufzufassenden Lastwiderstand mit einer Versorgungsspannung verbunden, während der Ausgangsemitter der Transistorstufe am Bezugspotential liegt. Um die Darlington-Stufe selbstleitend zu halten, ist der Kollektor über einen Basiswiderstand an den Basis-Eingangsanschluß der Darlington-Stufe gelegt. Damit zieht die bipolare Schaltstufe ihren Basisstrom über den Basiswiderstand direkt aus dem Ausgang der Schaltstufe. Die Sättigungsspannung des Transistors setzt sich aus den Basis-Emitter-Spannungen der Darlington-Stufe und dem Spannungsabfall über dem Basiswiderstand zusammen und beträgt typischerweise nicht mehr als 2 V. Wenn in einem Fehlerfall die Ansteuereinrichtung kein Steuersignal für die Schaltstufe liefert, wird die Schaltstufe direkt aus ihren Lastkreis mit Basisstrom versorgt und ist immer eingeschaltet, d. h. selbstleitend.

Aus J. Krause, J. Tihanyi: Smart SIPMOS: Der intelligente Leistungsschalter, Archiv für Elektrotechnik 72 (1989) 83-88 ist eine MOS-Schaltstufe bekannt, bei der ein MOS-Leistungstransistor von einer Ladungspumpe gesteuert wird. Der als high-side-Schalter mit masseseitiger Last ausgebildete Leistungstransistor und die Ladungspumpe sind am positiven Versorgungsspannungspol angeschlossen und die Ladungspumpe liegt auf Bezugspotential. Die Anordnung ist nicht selbstleitend.

Das Dokument JP-A 04 167 814 offenbart eine Schaltungsanordnung, bei der der Drain-Anschluß eines MOS-Transistors über ein NAND-Gate, eine Oszillationsschaltung und eine Ladungspumpe mit dem Gate-Anschluß des MOS-Transistors verbunden ist. Die Verbindung des Drain-Anschlußes mit dem Gate-Anschluß ist so ausgelegt, daß sich der MOS-Transistor selbst ausschaltet. Auch diese Anordnung ist nicht selbstleitend.

Das Dokument JP A 02 164 268 offenbart eine Schaltungsanordnung zur Vervielfältigung einer Gleichspannung, die als Ladungspumpe verwendet werden kann.

Das Dokument JP A 56 091 offenbart eine Schaltungsanordnung bei der ein Ringoszillator und eine Stufe zur Spannungsvervielfachung zusammenwirken.

Das Dokument JP-A 05 191 970 zeigt eine Spannungswandlerschaltung mit einem low-side MOS-Transistor, dessen Drain-Anschluß mit einer Ladungspumpe verbunden ist, die den Gateanschluß des Transistors über eine Treiberstufe steuert, wobei der Source-Anschluß des Transistors und die Ladungspumpe Masse als Bezugspotential aufweisen. Der Drainanschluß des MOS-Transistors ist über eine Boosterinduktivität an eine Eingangsspannung von 1V angeschlossen.

Ziel der Erfindung ist die Realisierung einer selbstleitenden Schaltstufe mit einem MOS-Transistor. Vorzugsweise kommt als MOS-Transistor ein Leistungstransistor mit DMOS-Struktur in Betracht, der insbesondere in für die Automobiltechnik geeigneten Technologien ein optimales Leistungsbauelement darstellt. Die Erfindung läßt sich jedoch auch mit anderen MOS-Transistoren realisieren.

Erreichen läßt sich dieses Ziel zweifellos dadurch, daß ein MOS-Transistor, beispielsweise vom DMOS-Typ, eine Verbindung von seinem Drainanschluß zu seinem Gateanschluß über einen Vorwiderstand aufweist. Im Vergleich zu einer bipolaren Darlington-Stufe ist die Sättigungsspannung beispielsweise eines DMOS-Transistors jedoch deutlich höher und für die Praxis nicht akzeptabel. Die erforderliche Gatespannung zur Ansteuerung eines DMOS-Transistors, die der Sättigungsspannung entspricht, ist üblicherweise größer als 2 V.

Die Erfindung sieht bei einer Schaltungsanordnung mit einem MOS-Transistor die im Anspruch 1 definierten Merkmale vor.

Die Erfindung hat den Vorteil, daß die Schaltstufe selbstleitend ist, und somit auch bei einem Ausfall der normal vorgesehenen Ansteuerung arbeitet. Zum Beispiel kann im Fall, daß die Ladungspumpe und ggf. der MOS-Transistor Elemente eines IC sind, während die Last extern zwischen dem MOS-Transistor und einem Versorgungsspannungspol liegt, die Ver sorgungsspannung des IC ausfallen oder unterbrochen werden, ohne daß die Funktion der Schaltstufe beeinträchtigt wird.

Die Erfindung hat den weiteren Vorteil, daß Ladungspumpen, d. h. Spannungsvervielfacherschaltungen bereits bei sehr geringen Betriebsspannungen, z. B. unter 2 V, arbeiten und Ausgangsspannungen erzeugen können, die zur Ansteuerung von MOS-Schaltstufentransistoren ausreichend sind. Die Bauelemente der Ladungspumpe können Niedervoltbauteile sein, weil die Ladungspumpe nicht auf die maximale Versorgungsspannung ausgelegt werden muß.

In einer Weiterbildung der Erfindung ist vorgesehen, daß zwischen dem Ausgang der Ladungspumpe und dem Gate des Transistors eine Regelschaltung zur Regelung der Spannung am Drainanschluß des Transistors auf einen konstanten Wert angeordnet ist. Dies bietet den Vorteil, daß unerwünschte Regelschwingungen im Lastkreis ausgeregelt werden.

Andere Weiterbildungen der Erfindung sind in Unteransprüchen gekennzeichnet.

Die Erfindung wird nachfolgend anhand von Ausführungsbeispielen näher erläutert. Es zeigen:
Figur 1 und Figur 2 zwei Ausführungsbeispiele einer erfindungsgemäßen Schaltungsanordnung,
Figur 3 ein Beispiel für eine Ladungspumpe und
Figur 4 ein Beispiel für eine Regelschaltung.

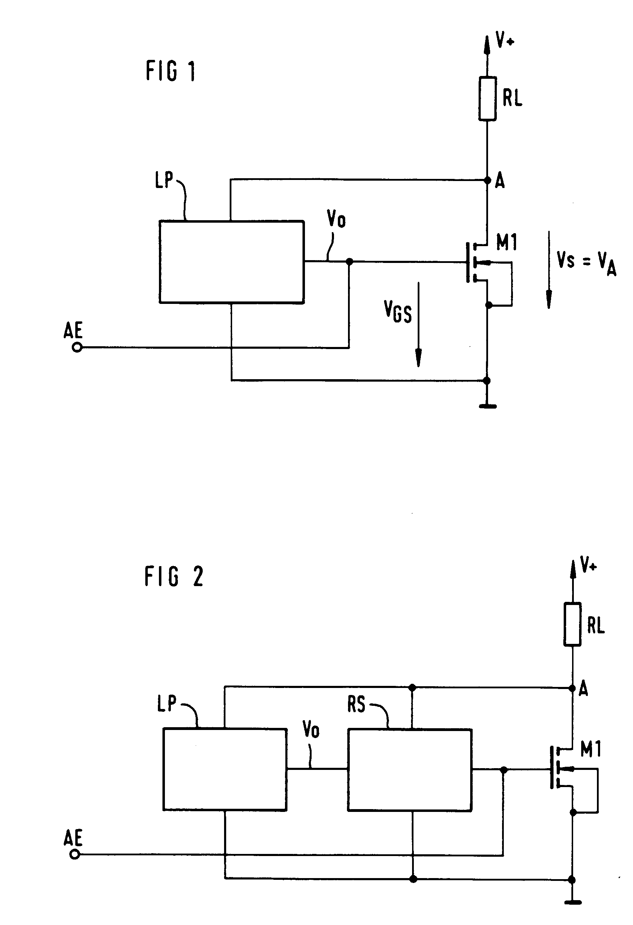

Gemäß Figur 1 enthält die Schaltungsanordnung einen MOS-Transistor M1, beispielsweise mit DMOS-Struktur, der im Ausführungsbeispiel als selbstsperrender n-Kanal-Transistor dargestellt ist. Es sind jedoch auch andere MOS-Transistoren möglich. Mit seiner Source ist der Transistor M1 an Bezugspotential geschaltet (low-side-Schalter). Der Drainanschluß A des Transistors M1 wird einerseits über einen Lastwiderstand RL, beispielsweise eine Kontrollampe von einer Spannung V+, beispielsweise einer Autobatterie versorgt. Andererseits ist der Ausgang A des Leistungstransistors M1 an den Eingang einer Ladungspumpe LP gelegt,die ausgangsseitig das Gate des Transistors M1 ansteuert. Das Gate von M1 ist außerdem mit einer Klemme AE verbunden, an der der Ausgang einer für den normalen Betrieb vorgesehenen, nicht dargestellten Ansteuereinrichtung angeschlossen ist. Die Ladungspumpe LP ist bezugsseitig mit der Source des Transistors M1 bzw. Bezugspotential verbunden.

Die Sättigungsspannung des Transistors M1 beträgt etwa 2 V. Die Ladungspumpe, d. h. die Spannungsvervielfacherschaltung LP ist so ausgelegt, daß sie mit der Sättigungsspannung des Transistors M1 betrieben werden kann. Ausgangsseitig erzeugt die Ladungspumpe LP eine Spannung V_{GS} von mindestens 5 V, die zur Ansteuerung des Transistors M1 ausreicht. Die Ladungspumpe kann aus Niedervoltbauelementen aufgebaut sein.

Die Ladungspumpe und gegebenenfalls der MOS-Transistor können Elemente eines IC sein. Die Last RL ist dann z. B. über eine nicht dargestellte Klemme mit dem MOS-Transistor M1 einerseits und mit dem Versorgungsspannungspol V+ verbunden.

In dem Fall, daß an der Klemme AE aufgrund eines Fehlers kein Steuersignal anliegt, z. B. wenn die Versorgungsspannung des IC unterbrochen ist, wird die Ladungspumpe LP über den Lastwiderstand RL mit Spannung versorgt und erzeugt ausgangsseitig eine Ansteuerspannung für den Transistor M1, der durchschaltet und den Lastkreis RL betreiben kann.

In der Praxis ist es möglich, daß der eingeschaltete Leistungstransistor M1 die Spannung an seinem Drainanschluß A soweit in Richtung auf das Bezugspotential herunterzieht, daß die Versorgungsspannung der Ladungspumpe nicht mehr zum Betrieb der Ladungspumpe und damit zur Ansteuerung des Transistors M1 ausreicht. Bei fehlender Ansteuerspannung schaltet der Transistor M1 ab, so daß die Spannung am Schaltungsknotenpunkt A ansteigen kann und das Wiederanlaufen der Ladungspumpe erfolgt.

Bei der in Figur 1 dargestellten Schaltungsanordnung einer selbstleitenden Schaltstufe mit einem MOS-Transistor sind Regelschwingungen im Lastkreis möglich, die gegebenenfalls unerwünscht sind. Als weitere vorteilhafte Ausführungsform sieht die Erfindung gemäß Figur 2 deshalb vor, daß zwischen dem Ausgang der Ladungspumpe LP und dem Gate des Transistors M1 eine Regelschaltung RS zur Regelung der Spannung am Drainanschluß A des Transistors auf einen konstanten Wert vorgesehen ist. Die Regelschaltung arbeitet dabei schneller als die in Figur 1 gezeigte Anordnung, so daß sich Regelschwingungen am Drainanschluß A nicht ausbilden können. Die Regelschaltung RS ist so aufgebaut, daß die Spannung am Knotenpunkt A detektiert wird und die detektierte Spannung eine Verringerung der Ansteuerspannung für den Transistor M1 und damit einen Anstieg des Durchlaßwiderstandes von M1 bewirkt, so daß die Spannung am Drainanschluß A wieder steigen kann.

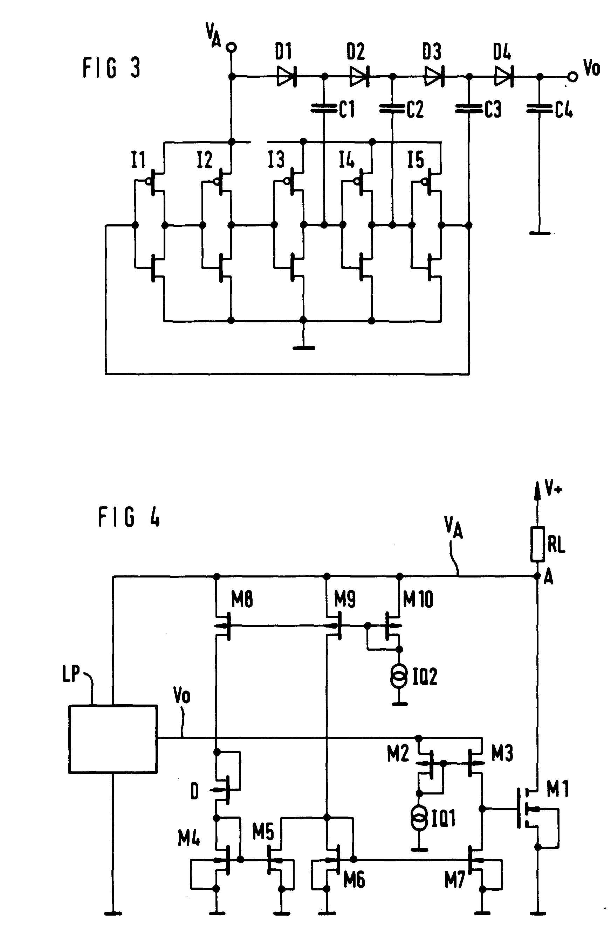

Figur 3 zeigt ein Ausführungsbeispiel einer Ladungspumpe LP. Es muß jedoch betont werden, daß sich für die Ladungspumpe alle bekannten Ladungspumpenschaltungen mit entsprechender Betriebsspannung eignen. Die Anzahl der Stufen der Ladungspumpe ist entsprechend der geforderten Spannungsvervielfachung ausgelegt, d. h. in Abhängigkeit von der Eingangsspannung und der erforderlichen Ausgangsspannung so gewählt, daß eine sichere Ansteuerung des nachgeschalteten MOS-Transistors gegeben ist. Die erfindungsgemaße Schaltungsanordnung eignet sich deshalb unabhängig von technologisch vorgegebenen Schwellenspannungen zur Ansteuerung aller MOS-Bauelemente.

Die in Figur 3 dargestellte Ladungspumpe ist selbstschwingend. Fünf CMOS-Inverterstufen I1 - I5 bilden einen Ringoszillator, bei dem der Ausgang des Inverters I5 auf den Eingang des Inverters I1 rückgekoppelt ist. Versorgt wird der Ringoszillator und die Spannungsvervielfacherschaltung von der Spannung V_{A} am Drainanschluß A des Transistors M1. Die drei Stufen I3 bis I5 des Ringoszillators werden zur Spannungsvervielfachung herangezogen. Die Vervielfacherschaltung enthält eine Diode D1, die die Spannung V_{A} an eine Elektrode der Kapazität C1 legt, deren andere Elektrode am Ausgang des Inverters I3 angeschlossen ist. Die nächsten Stufen der Spannungsvervielfacherschaltung enthalten jeweils eine Diode Di und eine Kapazität Ci, i=1,...4, die entsprechend am Verbindungspunkt einer Diode und einer Kapazität sowie einem Inverterausgang des Ringoszillators angeschlossen sind. Die letzte Stufe der Vervielfacherschaltung mit der Diode D4 und der Kapazität C4 ist diodenseitig am Verbindungspunkt von D3 und C3 und kapazitätsseitig an Bezugspotential angeschlossen. Der Ausgang des Verbindungspunktes von D4 und C4 ist mit dem Gateanschluß des Transistors M1 verbunden und liefert die Spannung Vo. Die in Figur 3 dargestellte Spannungsvervielfacherschaltung ermöglicht theoretisch eine Vervierfachung der Eingangsspannung V_{A}, praktisch ist jedoch nur etwa die dreifache Ausgangsspannung gegenüber der Eingangsspannung erzielbar. Das bedeutet, daß bei einer Eingangsspannung von 2 Volt, die der Sättigungsspannung des Transistors M1 entspricht, eine maximale Ausgangsspannung Vo von 6V erzielbar ist.

Figur 4 zeigt eine detaillierte Ausführungsform der Regelschaltung RS. Der Ausgang der Ladungspumpe LP wird über den Stromspiegel aus den Transistoren M2 und M3 an das Gate des Transistors M1 geschaltet. Der als Diode geschaltete Stromspiegeltransistor M2 wird dabei von der Stromquelle IQ1 versorgt, und der Ausgang des Transistors M3 liegt am Gate von M1. Ein weiterer Stromspiegel, der von einer Stromquelle IQ2 versorgt wird, wird durch die Transistoren M8, M9 und M10 gebildet, die sourceseitig mit dem Drainanschluß A des Transistors M1 verbunden sind. M10 ist als Diode geschaltet, während M8 und M9 zwei getrennte Ausgangskreise des Stromspiegels bilden. Der Ausgangskreis von M8 liegt in Reihe zu einem als Diode geschalteten MOS-Transistor D und zu einem als Diode geschalteten Transistor M4, der mit einem Transistor M5 einen weiteren Stromspiegel bildet. D kann auch eine bipolare Diode sein. M5 liegt parallel zu einem als Diode geschalteten Transistor M6, und die Parallelschaltung aus M5 und M6 liegt in Reihe zum Ausgang des Transistors M9. M6 bildet mit M7 einen weiteren Stromspiegel, wobei der Ausgang von M7 an den Ausgang von M3 und das Gate von M1 angeschlossen ist.

Im Betrieb wird die Ausgangsspannung Vo der Ladungspumpe LP mit der Stromquelle IQ1 und dem Stromspiegel M2, M3 an das Gate des Transistors M1 geschaltet. Damit schaltet Transistor M1 ein und die Spannung am Drainanschluß A sinkt ab. Wenn die Spannung V_{A} niedriger wird als die Summe aus der Sattigungsspannung des Transistors M8, der Schwellenspannung von D und der Schwellenspannung des Transistors M4, wird der Pfad aus den Elementen M8, D und M4 stromlos und der Transistor M5 sperrt. Damit wird die Drainspannung des Transistors M6 bzw. des Transistors M9 so angehoben, daß der als Diode geschaltete Transistor M6 leitet und den Stromspiegel aus den Transistoren M6 und M7 einschaltet. Der Transistor M7 entlädt dann das Gate des Transistors M1 bzw. verringert die Gate-Source-Spannung des Transistors M1. M1 leitet daraufhin schlechter, so daß die Spannung am Drainanschluß A wiederum steigen kann. Bei ausreichend hoher Spannung V_{A} wird der Stromspiegel aus M4 und M5 eingeschaltet, so daß Transistor M7 gesperrt wird und Transistor M1 wiederum besser leiten kann. Im eingeschwungenen Zustand des Regelkreises RS stellt sich am Drainanschluß A eine Spannung ein, die der Summe aus der Sättigungsspannung von M8 sowie der Schwellen- bzw.Diodenspannung von D und der Schwellenspannung von M4 entspricht.

Der Vorteil der erfindungsgemäßen Schaltungsanordnung besteht darin, daß MOS-Transistoren als Leistungsschalter verwendet werden können. Bei vergleichbarer Spezifikation des Lastkreises der Schaltstufe bietet beispielsweise ein DMOS-Transistor den Vorteil eines geringeren Flächenbedarfs für den Chip, eine höhere Spannungsfestigkeit und einen einfacheren Überlastschutz. Die Erfindung läßt sich vorteilhaft auch in reinen CMOS-Herstellprozessen, also ohne bipolare Bauelemente realisieren.

## Patentansprüche

1. Schaltungsanordnung mit einem MOS-Transistor (M1), dessen Drain-Anschluß (A) mit einer Ladungspumpe (LP) verbunden ist, die den Gateanschluß des Transistors steuert, und dessen Source-Anschluß an Bezugspotential angeschlossen ist, wobei der Source-Anschluß des Transistors und die Ladungspumpe (LP) ein gemeinsames Bezugspotential aufweisen und der gemeinsame Verbindungspunkt (A) von Drain-Anschluß des Transistors und der Ladungspumpe (LP) über eine Last (RL) an einem Versorgungsspannungspol (V +) liegt, derart, daß die Schaltungsanordnung selbstleitend ist, wobei die Ladungspumpe selbstschwingend ist und bei der Sättigungsspannung des MOS-Transistors betreibbar ist.

2. Schaltungsanordnung nach Anspruch 1,
**dadurch gekennzeichnet,**
daß die Ladungspumpe (LP) einen mehrstufigen Ringoszillator (I1 - I5) enthält, von dem zumindest mehrere Stufen zur Spannungsvervielfachung dienen.

3. Schaltungsanordnung nach Anspruch 1 oder 2,
**dadurch gekennzeichnet,**
daß die Ladungspumpe (LP) eine Betriebsspannung von in etwa der Höhe der Sättigungsspannung des Transistors (M1) und eine demgegenüber vervielfachte Ausgangsspannung (Vo) aufweist.

4. Schaltungsanordnung nach einem der Ansprüche 1 bis 3,
**dadurch gekennzeichnet,**
daß zwischen dem Ausgang der Ladungspumpe (LP) und dem Gate des Transistors (M1) eine Regelschaltung (RS) zur Regelung der Spannung am Drainanschluß (A) des Transistors auf einen konstanten Wert vorgesehen ist.

5. Schaltungsanordnung nach Anspüruch 4,
**dadurch gekennzeichnet,**
daß das mit dem Ausgang der Ladungspumpe verbundene Gate des Transistors (M1) über einen Schalter (M7) entladbar ist, wobei der Schalter aktiviert wird, wenn der Drainanschluß (A) des Transistors einen vorgegebenen Spannungswert unterschreitet.

6. Schaltungsanordnung nach einem der Ansprüche 1 bis 3,
**dadurch gekennzeichnet,**
daß ein Detektor (D, M4, M8) die Spannung am Drainanschluß (A) des Transistors detektiert und ein dem Detektor nachgeschalteter Schalter (M6, M7) mit dem Gate des Transistors (M1) verbunden ist.

7. Schaltungsanordnung nach einem der Ansprüche 1 bis 6,
**gekennzeichnet durch** Ausbildung in komplementärer MOS-Technik.

## Claims

1. Circuit arrangement having a MOS transistor (M1), whose drain terminal (A) is connected to a charge pump (LP) which controls the gate terminal of the transistor, and whose source terminal is connected to reference potential, the source terminal of the transistor and the charge pump (LP) having a common reference potential and the common junction point (A) of the drain terminal of the transistor and of the charge pump (LP) being connected via a load (RL) to a supply voltage pole (V+), in such a way that the circuit arrangement is normally on, the charge pump being free-running and being operable at the saturation voltage of the MOS transistor.

2. Circuit arrangement according to Claim 1, characterized in that the charge pump (LP) contains a multi-stage ring oscillator (I1 - I5), of which at least a plurality of stages serve for voltage multiplication.

3. Circuit arrangement according to Claim 1 or 2, characterized in that the charge pump (LP) has an operating voltage of about the level of the saturation voltage of the transistor (M1) and has an output voltage (Vo) that is multiplied in comparison therewith.

4. Circuit arrangement according to one of Claims 1 to 3, characterized in that a regulating circuit (RS) for regulating the voltage at the drain terminal (A) of the transistor to a constant value is provided between the output of the charge pump (LP) and the gate of the transistor (M1).

5. Circuit arrangement according to Claim 4, characterized in that the gate of the transistor (M1), which gate is connected to the output of the charge pump, can be discharged via a switch (M7), the switch being activated when the drain terminal (A) of the transistor falls below a predetermined voltage value.

6. Circuit arrangement according to one of Claims 1 to 3, characterized in that a detector (D, M4, M8) detects the voltage at the drain terminal (A) of the transistor, and a switch (M6, M7) which is connected downstream of the detector is connected to the gate of the transistor (M1).

7. Circuit arrangement according to one of Claims 1 to 6, characterized by a design using complementary MOS technology.

## Revendications

1. Montage comportant un transistor MOS (M1) dont la borne de drain (A) est reliée à une pompe de charge (LP), qui commande la borne de grille du transistor, et dont la borne de source est raccordée au potentiel de référence, la borne de source du transistor et la pompe de charge (LP) présentant un potentiel de référence commun et le point de jonction commun de la borne de drain (A) du transistor et de la pompe de charge (LP) se trouvant par l'intermédiaire d'une charge (RL) à un pôle de tension d'alimentation (V+), de telle sorte que le montage est autoconducteur, la pompe de charge étant auto-oscillante et pouvant fonctionner à la tension de saturation du transistor MOS.

2. Montage selon la revendication 1,
caractérisé par le fait que la pompe de charge (LP) contient un oscillateur annulaire à plusieurs étages (I1 à I5) parmi lesquels au moins plusieurs étages servent à la multiplication de tension.

3. Montage selon la revendication 1 ou 2,
caractérisé par le fait que la pompe de charge (LP) présente une tension de service environ égale à l'amplitude de la tension de saturation du transistor (M1) et une tension de sortie (Vo) multipliée par rapport à cette tension de service.

4. Montage selon l'une des revendications 1 à 3,
caractérisé par le fait qu'il est prévu entre la sortie de la pompe de charge (LP) et la grille du transistor (M1) un circuit de réglage (RS) destiné à régler sur une valeur constante la tension à la borne de drain (A) du transistor.

5. Montage selon la revendication 4,
caractérisé par le fait que la grille, reliée à la sortie de la pompe de charge, du transistor (M1) peut être déchargée par l'intermédiaire d'un commutateur (M7), le commutateur étant activé lorsque la borne de drain (A) du transistor devient inférieure à une valeur de tension prescrite.

6. Montage selon l'une des revendications 1 à 3,
caractérisé par le fait qu'un détecteur (D, M4, M8) détecte la tension à la borne de drain (A) du transistor et un commutateur (M6, M7) branché du côté aval du détecteur est relié à la grille du transistor (M1).

7. Montage selon l'une des revendications 1 à 6,
caractérisé par une conception en technique MOS complémentaire.
